# EUROPEAN PATENT APPLICATION

(11) **EP 4 648 094 A1**
(43) Date of publication of application: **12.11.2025**
(21) Application number: 24174843.3
(22) Date of filing: 08.05.2024
(51) Int. Cl.: H01L 23/00

(54) **METHOD FOR CONNECTING TWO METAL LAYERS AND ARRANGEMENT COMPRISING TWO METAL LAYERS CONNECTED TO EACH OTHER**

(71) Applicant: Infineon Technologies AG, 85579 Neubiberg (DE)
(72) Inventor: OTTO, Frederik, 59399 Olfen (DE); BAUMANN, Ingo, 85560 Ebersberg (DE)
(74) Representative: Westphal, Mussgnug & Partner, Patentanwälte mbB

(57) **Abstract**

A method comprises bringing a first layer or element (92) comprising or consisting of silver in direct contact with a second layer or element (90) consisting of copper or a copper alloy, and heating the second layer or element (90) being in direct contact with the first layer or element (92) in an oxygen containing atmosphere, thereby forming a third layer (94) consisting of copper(I) oxide, Cu₂O, between the first layer or element (92) and the second layer or element (90), wherein the third layer (94) directly adjoins the first layer or element (92) and the second layer or element (90).

## Description

### TECHNICAL FIELD

The instant disclosure relates to a method for connecting two metal layers and an arrangement comprising two metal layers connected to each other, in particular a method for connecting a silver layer and a copper layer to each other.

### BACKGROUND

Power semiconductor module arrangements often include at least one substrate. A semiconductor arrangement including a plurality of controllable semiconductor elements (e.g., two or more IGBTs) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements as well as other elements (e.g., elements for forming electrical connections between different elements of the semiconductor module arrangement, or between elements of the semiconductor module arrangement and any external elements) are mounted, for example, on the first metallization layer. Copper and silver are materials that are often used in semiconductor module arrangements due to their specific physical properties. Further, copper and silver generally have an excellent electrical and thermal conductivity which is generally desirable in semiconductor module arrangements. A semiconductor module arrangement therefore may include a plurality of copper-silver interfaces.

There is a need for a method with which reliable interfaces may be formed between copper and silver layers.

### SUMMARY

A method includes bringing a first layer or element comprising or consisting of silver in direct contact with a second layer or element consisting of copper or a copper alloy, and heating the second layer or element being in direct contact with the first layer or element in an oxygen containing atmosphere, thereby forming a third layer consisting of copper(I) oxide, Cu₂O, between the first layer or element and the second layer or element, wherein the third layer directly adjoins the first layer or element and the second layer or element.

An arrangement includes a first layer or element comprising or consisting of silver, a second layer or element consisting of copper or a copper alloy, and a third layer consisting of copper(I) oxide, Cu₂O, wherein the third layer is arranged between the first layer or element and the second layer or element and directly adjoins each of the first layer or element and the second layer or element.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of an arrangement comprising a semiconductor body mounted on a substrate.
Figure 3 is a cross-sectional view of another arrangement comprising a semiconductor body mounted on a substrate.
Figure 4, including Figures 4A and 4B, schematically illustrates a method according to embodiments of the disclosure.
Figure 5 schematically illustrates a copper layer and a silver layer mounted to each other by means of conventional methods.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not necessarily require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connectable pads and includes at least one semiconductor element with electrodes.

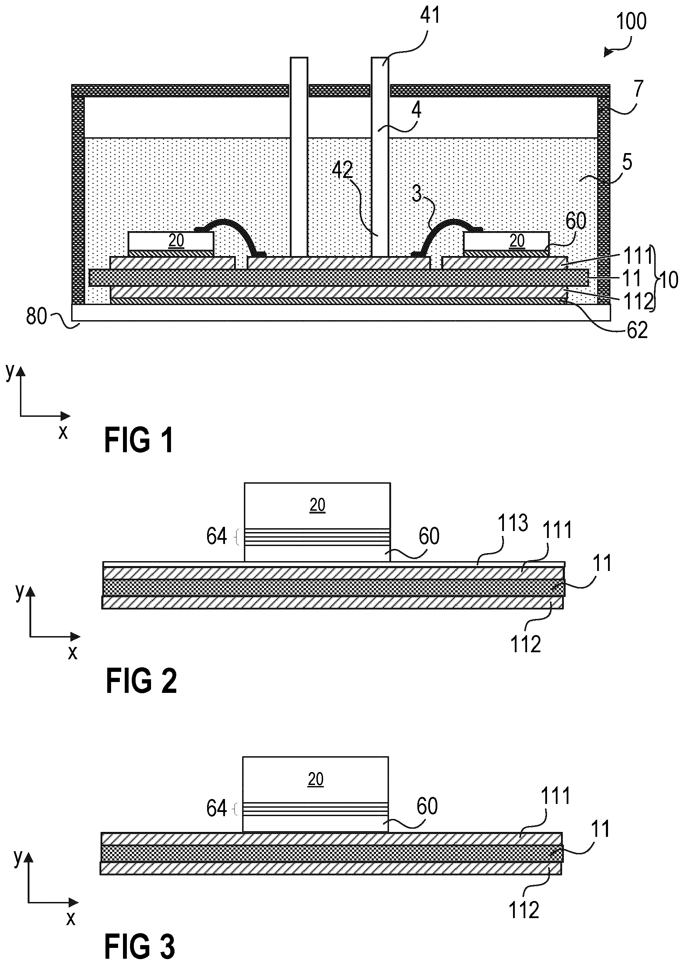

Referring to Figure 1, a cross-sectional view of a conventional power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AlN, ZrO₂, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, SiN or BN and may have a diameter of between about 1µm and about 50µm.

The substrate 10 is arranged in a housing 7. In the example illustrated in Figure 1, the substrate 10 is arranged on a base plate 80 which forms a base surface of the housing 7, while the housing 7 itself solely comprises sidewalls and, optionally, a top or cover. In some power semiconductor module arrangements 100, more than one substrate 10 is arranged on the same base plate 80 and within the same housing 7. The base plate 80 may comprise a layer of a metallic material such as, e.g., AlSiC, A1C, Al, MgSiC, or Cu. Other materials, however, are generally also possible. The base plate 80, however, may also be omitted (so-called base plate less modules). In such cases, the substrate 10 itself may form a base surface of the housing 7, for example. It is, however, also possible that the housing 7 comprises a base surface and one or more substrates 10 are arranged on the base surface and inside the housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. In some semiconductor modules 100, the second metallization layer 112 may be a structured layer. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates, connection clips, or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example. The one or more substrates 10 may be mechanically and thermally connected to a base plate 80 by means of a connection layer 62. The connection layer 62 in conventional semiconductor modules 100 may be an electrically insulating adhesive layer, a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 provide an electrical connection between the inside and the outside of the housing 7. The terminal elements 4 may be electrically connected to the first metallization layer 111 with a second end 42, while a first end 41 of the terminal elements 4 protrudes out of the housing 7. The terminal elements 4 may be electrically contacted from the outside at their first end 41.

Arranging the terminal elements 4 centrally on the substrate 10 is only an example. According to other examples, terminal elements 4 may be arranged closer to or adjacent to the sidewalls of the housing 7. The terminal elements 4 may comprise or consist of copper or a copper alloy, for example. The second end 42 of a terminal element 4 may be electrically and mechanically connected to the substrate 10 by means of an electrically conductive connection layer (not specifically illustrated in Figure 1). Such an electrically conductive connection layer may be a solder layer, a layer of an electrically conductive adhesive, or a layer of a sintered metal powder, e.g., a sintered silver (Ag) powder, for example. Alternatively, the terminal elements 4 may also be coupled to the substrate 10 by means of ultrasonic welding.

The power semiconductor module arrangement 100 may further include an encapsulant 5. The encapsulant 5 may consist of or include a cured silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their first ends 41, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged inside the housing 7, from certain environmental conditions and mechanical damage. The encapsulant 5 is further configured to electrically insulate areas with different potentials (e.g., different sections of the first metallization layer 111) from each other.

As has been outlined above, a semiconductor module 100 generally comprises a plurality of elements that are electrically and mechanically connected to other elements, e.g., substrate 10 connected to base plate 80, semiconductor bodies 20, terminal elements 4, or electrical connections 3 connected to substrate 10, etc. Copper and silver are materials that are often used in semiconductor module arrangements due to their specific physical properties. Further, copper and silver generally have an excellent electrical and thermal conductivity which is generally desirable in semiconductor module arrangements. A semiconductor module arrangement therefore may include a plurality of copper-silver interfaces.

Several examples of copper-silver interfaces are schematically illustrated in Figure 2. A semiconductor body 20 may be attached to the first metallization layer 111 of a substrate 10, which may consist of copper or a copper alloy, by means of a sinter layer 60 (e.g., a sintered silver (Ag) layer), for example. In some semiconductor modules, an additional metallization layer 113 is formed on the first metallization layer 111 and between the first metallization layer 111 and the sinter layer 60. Such an additional metallization layer 113 may comprise or consist of silver, for example, and may provide an oxide-free surface on the first metallization layer 111 that is suitable for soldering or sintering processes. That is, a copper-silver interface may be formed between the first metallization layer 111 and the additional metallization layer 113. A semiconductor body 20 often comprises a backside metallization stack 64 comprising two or more different layers. In the example illustrated in Figure 2, the metallization stack 64 comprises a first backside metallization layer comprising or consisting of aluminum, a second backside metallization layer comprising or consisting of titanium, a third backside metallization layer consisting of copper or a copper alloy, and a fourth backside metallization layer comprising or consisting of silver. The first backside metallization layer usually serves as a common electrical contact layer on silicon dies, and the second backside metallization layer usually serves as a barrier for diffusion of aluminum into the lower layers of the backside metallization stack 64. The third backside metallization layer generally enhances the humidity robustness of sintered semiconductor dies, and the fourth backside metallization layer provides an oxide-free surface suitable for soldering or sintering processes. The first backside metallization layer directly adjoins the semiconductor body 20, the second backside metallization layer directly adjoins the first backside metallization layer, the third backside metallization layer directly adjoins the second backside metallization layer, and the fourth backside metallization layer directly adjoins the third backside metallization layer. When the semiconductor body 20 is arranged on a sinter layer 60, the fourth backside metallization layer directly adjoins the sinter layer 60. A copper-silver interface is formed between the third backside metallization layer and the fourth backside metallization layer.

It is, however, also possible that the additional metallization layer 113 and the fourth backside metallization layer be omitted (e.g., backside metallization stack 64 comprises three, instead of four different layers). Such silver layers generally provide an oxide-free surface, but may be omitted, for example, when the soldering or sintering process is performed in a reducing gas atmosphere, for example. An arrangement without the additional metallization layer 113 and the fourth backside metallization layer is schematically illustrated in Figure 3. In this example, copper-silver interfaces are formed between the first metallization layer 111 and the sinter layer 60, and between the third backside metallization layer and the sinter layer 60, for example.

Figures 2 and 3 are merely intended to specifically illustrate some exemplary copper-silver interfaces that may be present in a semiconductor module. What will be described in the following, however, is not restricted to this specific type of layers and copper-silver interfaces. Copper-silver interfaces may be present between any other elements or layers (e.g., second metallization layer 112 and connection layer 62, or base plate 80 and connection layer 62, terminal element 4 and connection layer, etc.) of a semiconductor module. Any connections formed between an element consisting of copper or a copper alloy and another element comprising or consisting of silver need to remain stable over the entire lifetime of the semiconductor module. The respective copper-silver interfaces are generally required to conduct electrical currents with low resistivity. At the same time, a sufficient mechanical strength should generally be provided.

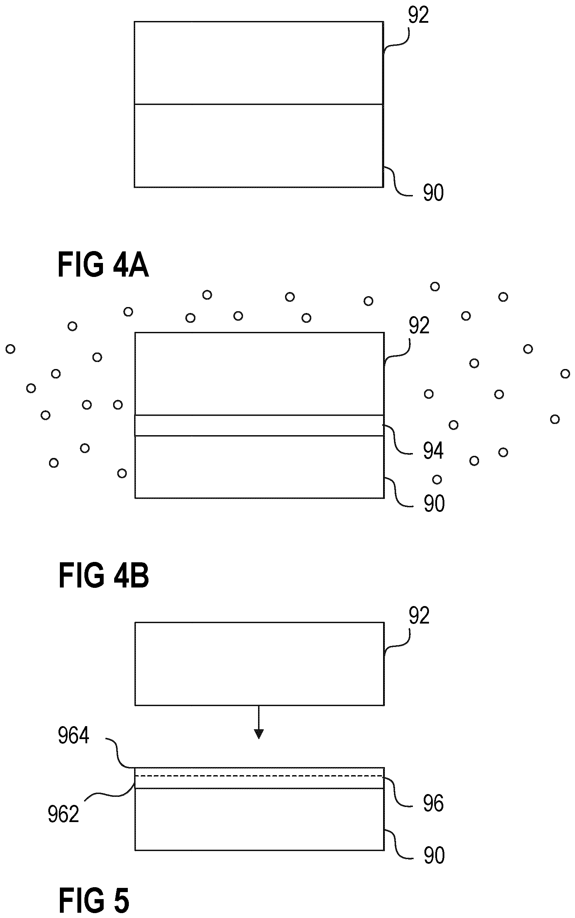

Now referring to Figures 4A and 4B, a method for forming a connection between a copper layer and a silver layer is schematically illustrated. A connection formed by means of the method has a significantly increased mechanical strength, as compared to connections formed by means of conventional methods. The method comprises bringing a first layer or element 92 comprising or consisting of silver in direct contact with a second layer or element 90 consisting of copper or a copper alloy, and heating the second layer or element 90 being in direct contact with the first layer or element 92 in an oxygen containing atmosphere, thereby forming a third layer 94 consisting of copper(I) oxide, Cu₂O, between the first layer or element 92 and the second layer or element 90, wherein the third layer 94 directly adjoins the first layer or element 92 and the second layer or element 90.

As has been outlined above, there may be cases where a copper layer or element is arranged on top of a silver layer or element. In other cases, a silver layer or element may be arranged on top of a copper layer or element. This is of no relevance for the method described herein. Instead of horizontally, the layers or elements could also be arranged in any other orientation (e.g., vertically). Further, it is of no relevance in which way the layers or elements 90, 92 are brought into contact with each other. For example, one pre-fabricated layer or element could be arranged on another pre-fabricated layer or element. It is, however, also possible to form a layer on top of another layer or an element, e.g., by means of sputtering techniques, deposition techniques (e.g., chemical vapor deposition, physical vapor deposition), electrochemical plating methods, or in any other suitable way. A first layer 92 may also be sintered to a second layer 90. Other examples include suitable welding techniques and solid state bonding. A surface of the first layer or element 92 and a surface of the second layer or element 90, which are brought into direct contact with each other, are generally comparably large. A thickness of respective layers 90, 92 in a semiconductor module may be in the range of one hundred or several hundreds of nanometers, for example. The thickness of the respective layers 90, 92 is generally a thickness is a direction that is perpendicular to the copper-silver interface formed between the layers 90, 92. Elements of a semiconductor module, e.g., terminal elements, conductor rails, connection plates, or base plates consisting of copper or a copper alloy, however, may have significantly larger dimensions.

Irrespective of how the first layer or element 92 and the second layer or element 90 are formed, and irrespective of how the layers or elements 90, 92 are brought in direct contact with each other, there is no additional layer between the first layer or element 92 and the second layer or element 90 at the time of bringing the layers or elements in direct contact with each other. In particular, there is no oxide layer between the first layer or element 92 and the second layer or element 90. The formation of an oxide layer may either be prevented, or an oxide layer present on the first layer or element 92 and/or the second layer or element 90 may be removed before the layers or elements 90, 92 are brought in direct contact with each other. According to the method described herein, an oxide layer is only formed after the layers or elements 90, 92 have been brought into direct contact with each other. This is schematically illustrated in Figure 4B. The first layer or element 92 being in direct contact with the second layer or element 90 is arranged in an oxygen (e.g., O₂) containing atmosphere. The layers or elements 90, 92 arranged in the oxygen containing atmosphere are heated to temperatures of 150°C or more. According to one example, the layers or elements 90, 92 in the oxygen containing atmosphere are even heated to temperatures of 190°C or more. Heating the layers or elements 90, 92 facilitates the formation of a third layer 94 consisting of copper(I) oxide, Cu₂O, between the first layer or element 92 and the second layer or element 90. Copper and its alloys are less noble than silver. Therefore, the oxygen contained in the atmosphere will react with the copper and form copper(I) oxide, Cu₂O at the interface between the first layer or element 92 and the second layer or element 90. Silver generally possesses a native oxide at room temperature which is thermodynamically stable. This native oxide, however, becomes unstable when heated. When the native oxide is removed, the silver layer becomes highly permeable to oxygen diffusion. Under conditions close to that of conventional ambient atmosphere, this effect occurs in the range of between 150°C and 250°C, depending on the exact conditions, most importantly on the oxygen-partial pressure. Once the native oxide has been removed, oxygen can rapidly diffuse through the remaining bulk silver towards the copper-silver interface, where it forms copper(I) oxide, Cu₂O, with the copper.

The oxygen may penetrate into the first layer or element 92 via its side surfaces. That is, during the step of forming the third layer 94, the side surfaces of at least the first layer or element 92 and optionally also the second layer or element 90 remain accessible. The side surfaces of the first layer or element 92 are generally essentially perpendicular to the surface of the first layer or element 92, and the side surfaces of the second layer or element 90 are generally essentially perpendicular to the surface of the second layer or element 90 which are attached to each other.

A direct interface between a first layer or element 92 comprising or consisting of silver and a second layer or element 90 consisting of copper or a copper alloy generally has a satisfying electrical conductivity and mechanical strength. If, however, a third layer 94 consisting of copper(I) oxide, Cu₂O, is subsequently formed between the first layer or element 92 and the second layer or element 90, at least the mechanical strength of the connection between the first layer or element 92 and the second layer or element 90 is increased. This, however, is only the case if the step of forming the third layer 94 is performed after bringing the first layer or element 92 in direct contact with the second layer or element 90. The mechanical strength increases mainly due to the following two mechanisms. First, silver and copper both have a face-centered cubic crystal structure, however, with significantly different lattice constants (a_{Ag} = 0.4085 nm; a_{Cu} = 0.3615nm). That is, there exists a significant structural mismatch between the lattices of pure silver and copper which may adversely affect the strength of an interface formed between the two materials. Copper(I) oxide, Cu₂O, is able to alleviate these differences by forming epitaxially on copper and having a cubic lattice with a lattice constant that is closer to the lattice constant of silver (a_{Cu2O} = 0.4260 nm). Second, it is possible to form a strong chemical bond between silver and copper(I) oxide, Cu₂O.

A resulting arrangement comprises a first layer or element 92 comprising or consisting of silver, a second layer or element 90 consisting of copper or a copper alloy, and a third layer 94 consisting of copper(I) oxide, Cu₂O, wherein the third layer 94 is arranged between the first layer or element 92 and the second layer or element 90 and directly adjoins each of the first layer or element 92 and the second layer or element 90. The third layer 94 may have a thickness of less than 10 nanometers, of between 10 nanometers and 1 micrometer, or between 1 micrometer and 10 micrometers, for example. The thickness of the third layer 94 defines a distance between the first layer or element 92 and the second layer or element 90 in the resulting arrangement. Thin copper(I) oxide, Cu₂O, layers (e.g., of less than 1 micrometer, or of less than 10 nanometers) already increase the mechanical strength of the interface, but may me formed at lower costs than thicker layers, as the process time is shorter when forming thin layers.

As has been described above, the first layer or element 92 may be a sinter layer, for example. The second layer or element 90 may be one of a metallization layer 111, 112 of a substrate 10 of a semiconductor module, a layer of a backside metallization stack 64 of a semiconductor body 20, a terminal element 4 of a semiconductor module, a base plate 80 of a semiconductor module, and a connection plate, connection clip, or conductor rail of a semiconductor module, for example.

If an oxide layer 96 is formed before bringing the first layer or element 92 and the second layer or element 90 into contact with each other, this results in a somewhat different arrangement. This is schematically illustrated in Figure 5. In Figure 5, an oxide layer 96 is first formed on the second layer or element 90. The surface of the second layer or element 90 is not in contact with the first layer 92, and is directly accessible by oxygen. The resulting oxygen layer 96 in this case is not a pure copper(I) oxide, Cu₂O. The resulting oxygen layer 96 in this case generally comprises two sublayers. Namely a first sub-layer 962 consisting of copper(I) oxide, Cu₂O, and a second sub-layer 964 consisting of copper(II) oxide, CuO. That is, there is no copper(I) oxide, Cu₂O, layer which directly contacts both of the first layer or element 92 and the second layer or element 90, because an additional copper(II) oxide, CuO, layer is arranged between the copper(I) oxide, Cu₂O, layer and the first layer or element 92. An arrangement formed by means of the method according to embodiments of the disclosure, therefore, can be easily distinguished from arrangements formed by means of conventional methods (i.e. forming an oxide layer before bringing the silver and copper layer in contact with each other).

In Figures 4A and 4B, only the first layer or element 92 and the second layer or element 90 which are relevant for the method described herein are illustrated. Such layers or elements 90, 92, however, may be arranged in a semiconductor module, or may be attached to elements of a semiconductor module, for example. Any other layers or elements have been omitted in Figure 4 for the sake of clarity. As the side surfaces of at least the first layer or element 92, and optionally also the second layer or element 90 need to be accessible by oxygen during the heating step (at least in the vicinity of the copper-silver interface), the method described herein may be performed before forming an encapsulant 5, for example. An encapsulant 5, as has been described with respect to Figure 1 above, generally covers any side surfaces of the elements and layers of the semiconductor module 100. Forming an encapsulant 5 after forming the third layer 94, however, may prevent further oxygen from subsequently penetrating into the layers or elements 90, 92. Any oxygen subsequently penetrating into the layers or elements 90, 92 could further increase a thickness of the third layer 94, which may not be desired. That is, by forming an encapsulant 5, thereby covering the side surfaces of the first and second layers or elements 92, 90, a third layer 94 having a defined thickness may be formed which does not unintentionally increase further during the lifetime of the semiconductor module 100.

The method and resulting arrangement according to embodiments of the disclosure have been described with reference to semiconductor modules above. The method, however, is not restricted to connecting elements of a semiconductor arrangement to each other, but could be used in any other kind of application, or any other kind of electronic device as well where forming a stable connection between a silver layer and a copper layer is required.

## Claims

1. A method comprises:
bringing a first layer or element (92) comprising or consisting of silver in direct contact with a second layer or element (90) consisting of copper or a copper alloy; and
heating the second layer or element (90) being in direct contact with the first layer or element (92) in an oxygen containing atmosphere, thereby forming a third layer (94) consisting of copper(I) oxide, Cu₂O, between the first layer or element (92) and the second layer or element (90), wherein the third layer (94) directly adjoins the first layer or element (92) and the second layer or element (90).

2. The method of claim 1, wherein heating the second layer or element (90) being in direct contact with the first layer or element (92) comprises heating the second layer or element (90) being in direct contact with the first layer or element (92) to temperatures of 150°C or more, or to temperatures of 190°C or more.

3. The method of claim 1, wherein forming a third layer (94) consisting of copper(I) oxide, Cu₂O, between the first layer or element (92) and the second layer or element (90) comprises forming a third layer (94) having a thickness of less than 10 nanometers, of between 10 nanometers and 1 micrometer, or of between 1 micrometer and 10 micrometers.

4. The method of any of claims 1 to 3, wherein bringing a first layer or element (92) comprising or consisting of silver in direct contact with a second layer or element (90) consisting of copper or a copper alloy comprises forming a first layer (92) on a second layer or element (90), or forming a second layer (90) on a first layer or element (92) by means of sputtering, chemical vapor deposition, physical vapor deposition, or an electrochemical plating method.

5. The method of any of the preceding claims, further comprising:
removing an oxide layer present on the first layer or element (92) and/or the second layer or element (90) before the first and second layers or elements (90, 92) are brought in direct contact with each other.

6. An arrangement comprising:
a first layer or element (92) comprising or consisting of silver;
a second layer or element (90) consisting of copper or a copper alloy; and
a third layer (94) consisting of copper(I) oxide, Cu₂O, wherein
the third layer (94) is arranged between the first layer or element (92) and the second layer or element (90) and directly adjoins each of the first layer or element (92) and the second layer or element (90).

7. The arrangement of claim 6, wherein the third layer (94) has a thickness of less than 10 nanometers, of between 10 nanometers and 1 micrometer, or of between 1 micrometer and 10 micrometers.

8. The arrangement of claim 6 or 7, wherein the first layer or element (92) is a sinter layer.

9. The arrangement of any of claims 6 to 8, wherein the second layer or element (90) is one of a metallization layer (111, 112) of a substrate (10) of a semiconductor module, a layer of a backside metallization stack (64) of a semiconductor body (20), a terminal element (4) of a semiconductor module, a base plate (80) of a semiconductor module, and a connection plate, connection clip, or conductor rail of a semiconductor module.
